# EUROPEAN PATENT APPLICATION

(11) **EP 4 539 089 A2**
(43) Date of publication of application: **16.04.2025**
(21) Application number: 24204627.4
(22) Date of filing: 04.10.2024
(51) Int. Cl.: H01J 37/07, H01J 37/26, H01J 3/40

(54) **DRY ELECTRON SOURCE ENVIRONMENT**

(30) Priority: 11.10.2023 US 202318485133
(71) Applicant: FEI COMPANY, Hillsboro, OR 97124 (US)
(72) Inventor: DOLGOV, Alexandr, 5651 GG Eindhoven (NL); VAN HELVERT, Leo, 5651 GG Eindhoven (NL)
(74) Representative: Boult Wade Tennant LLP

(57) **Abstract**

A charged particle microscope system, comprising an electron source housing a Wehnelt electrode and a cathode, wherein the electron source may include a dry environment defining a volume between the Wehnelt electrode and the cathode that may be substantially water-free, a beam column including a plurality of electromagnetic lens elements, and a vacuum chamber including a sample holder. An electron beam axis may be defined from the cathode to the sample holder.

## Description

### CROSS-REFERENCE TO RELATED APPLICATION

This application claims priority to us non-provisional application 18/485,133, filed October 11, 2023, the disclosure of which is incorporated herein by reference in its entirety.

### BACKGROUND OF THE INVENTION

Electron microscopes are used as imaging tools by focusing an electron beam at a sufficient size from an electron emitter onto a sample and then detecting the reflection of those electrons to generate a high-resolution image of the sample. One step of focusing and controlling the size of the electron beam may include emitting electrons through an aperture in a Wehnelt electrode. The Wehnelt electrode is charged to a negative bias voltage relative to the electron emitter to generate an electrostatic field around the Wehnelt electrode that repulses the electrons toward the center of the aperture in the Wehnelt electrode, thus concentrating the electron beam emitted through the aperture. New charged particle microscope systems optimizing the use of Wehnelt electrodes are desired.

### BRIEF SUMMARY OF THE INVENTION

One aspect of the disclosure provides for a charged particle microscope system, comprising an electron source housing a Wehnelt electrode and a cathode, wherein the electron source includes a dry environment defining a volume between the Wehnelt electrode and the cathode that is substantially water-free, a beam column including a plurality of electromagnetic lens elements, and a vacuum chamber including a sample holder. An electron beam axis is defined from the cathode to the sample holder. The dry environment may be substantially water-free when the dry environment may include less than 5% humid. The dry environment may be substantially oxygen-free. The dry environment may be substantially oxygen-free when the dry environment may include less than 5% oxygen. The charged particle microscope may further comprise a first cold trap positioned between the beam column and the Wehnelt electrode. The first cold trap may include a first adsorbent surface defining a first cold region at a first temperature substantially lower than a freezing point of water and a first heat-removal element coupled to the first cold surface. The first heat-removal element may include a Peltier cooling system. The first heat-removal element may include at least one of a circulating element in fluid communication with a reservoir housing coolant. The coolant may include at least one of a liquid nitrogen or dry ice in acetone. The charged particle microscope system may further comprise a turbopump in fluid communication with the electron source and a second cold trap may be positioned between the turbopump and the electron source. The second cold trap may include a second adsorbent surface defining a second cold region at a second temperature substantially lower than a freezing point of water and a second heat-removal element may be coupled to the second cold surface. The second adsorbent surface may include a plurality of channels and the plurality of channels may each define a channel cold region. The charged particle microscope system may further comprise an inert gas reservoir housing an inert gas and may include an outlet in fluid communication with the electron source and a first turbopump in fluid communication with the electron source and the outlet to transport at least a portion of the inert gas into the dry environment. The first turbopump may create a first pressure in the electron source greater than a second pressure at the outlet. The charged particle microscope system may further comprise a second turbopump in fluid communication with the vacuum chamber and beam column. The outlet may be positioned between the electron source and the second turbopump, and the second turbopump may create a third pressure in the beam column greater than the second pressure. The charged particle microscope system may further comprise a third turbopump in fluid communication with the vacuum chamber. The third turbopump may create a fourth pressure greater than the third pressure. The inert gas may include at least one of argon, nitrogen, dry air, and helium. The outlet may be positioned in the beam column. The charged particle microscope may further comprise a container housing the electron source, beam column, and the vacuum chamber. The container may include a dry internal volume.

Another aspect of the disclosure provides for a charged particle microscope system, comprising an electron source housing a Wehnelt electrode and a cathode in a dry environment that is substantially water-free, a beam column including a plurality of electromagnetic lens elements, and a vacuum chamber including a sample holder. The electron beam axis is defined from the cathode to the sample holder. The charged particle microscope system may further comprise a turbopump in fluid communication with the electron source, a first cold trap may be positioned between the beam column and the Wehnelt electrode, a second cold trap may be positioned between the turbopump and the electron source. The first cold trap may include a first adsorbent surface defining a first cold region at a first temperature substantially lower than a freezing point of water and a first heat-removal element may be coupled to the first cold surface. The second cold trap may include a second adsorbent surface defining a second cold region at a second temperature substantially lower than a freezing point of water and a second heat-removal element may be coupled to the second cold surface. The charged particle microscope system may further comprise an inert gas reservoir housing an inert gas and may include an outlet in fluid communication with the electron source, a first turbopump in fluid communication with the electron source and the outlet to transport at least a portion of the inert gas into the dry environment, and a second turbopump in fluid communication with the vacuum chamber and beam column. The outlet may be positioned between the electron source and the second turbopump, the first turbopump may create a first pressure in the electron source greater than a second pressure at the outlet, and the second turbopump may create a third pressure in the beam column greater than the second pressure.

Another aspect of the disclosure provides for a charged particle microscope system, comprising an electron source housing a Wehnelt electrode and a cathode electrode. The electron source includes a dry environment defining a volume between the Wehnelt electrode and the cathode electrode that is substantially water-free, a beam column including a plurality of electromagnetic lens elements, and a vacuum chamber including a sample holder. An electron beam axis is defined from the cathode electrode to the sample holder.

### BRIEF DESCRIPTION OF THE DRAWINGS

A further understanding of the nature and advantages of various embodiments may be realized by reference to the following figures. In the appended figures, similar components or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.
FIG. 1A depicts a simplified cross-sectional view of an example charged particle microscope system according to an embodiment of the disclosure.
FIG. 1B depicts a cross-sectional view of the electron source of the charged particle microscope system of FIG. 1A according to an embodiment of the disclosure.
FIG. 2A depicts a simplified cross-sectional view of an example charged particle microscope system according to an embodiment of the disclosure.
FIG. 2B depicts a cross-sectional view of the electron source and cold traps of the charged particle microscope system of FIG. 2A according to an embodiment of the disclosure.
FIG. 3 depicts a simplified cross-sectional view of an example charged particle microscope system according to an embodiment of the disclosure.
FIG. 4 depicts a simplified cross-sectional view of an example charged particle microscope system according to an embodiment of the disclosure.
FIG. 5 depicts an example graph of Wehnelt electrode voltage over time according to an embodiment of the disclosure.
FIG. 6 depicts an example graph of Wehnelt electrode voltage over time according to an embodiment of the disclosure.
FIG. 7 depicts an example graph of Wehnelt electrode voltage over time according to an embodiment of the disclosure.
FIG. 8 depicts an example graph of Wehnelt electrode voltage over time according to an embodiment of the disclosure.

### DETAILED DESCRIPTION OF THE INVENTION

Electron microscopy provides high-resolution imaging by detecting backscattered electrons (BSEs) produced by the elastic scattering of a beam of electrons emitted from an electron emitter that interact with atoms of a sample. In one example, the electrons may be emitted from a cathode electrode that is heated by an electric current. The emitted electrons are attracted to an anode placed downstream of the cathode electrode, thus forming an electron beam roughly directed to the sample. However, to achieve a useful image, the electron beam must be further focused toward the sample at a sufficient size.

One means of focusing and controlling the electron beam includes using a Wehnelt electrode. The Wehnelt electrode is charged with a negative bias voltage to create an electric field that repulses the electrons emitted from the cathode electrode as well as controlling the current emission of the electron beam. The electron beam emitted from the cathode electrode may be directed at an aperture defined by the Wehnelt electrode such that the electric field of the Wehnelt electrode allows electron emission only from the area defined by the electric field surrounding the aperture. In this manner, the Wehnelt electrode may assist in focusing and controlling of the electron beam toward the sample.

However, the electrons emitted from the cathode electrode may ionize the gases around the cathode electrode and the Wehnelt electrode (e.g., in the electron source). The positively ionized gas particles can be attracted to the electric field generated by the Wehnelt electrode, thus forming a deposit layer on the Wehnelt electrode. In particular, the ionized gas particles may be particles that have evaporated from the cathode electrode through oxidation of the cathode electrode. This deposition layer can interfere with the electric field generated by the Wehnelt electrode, which, in turn, may disrupt the focus of the electron beam. This disruption may be severe enough that the electron beam cannot be corrected later on in the beam column.

This issue may be especially pronounced for tabletop electron microscopes as the pumps used in these systems are smaller than larger electron microscopes, such as floor electron microscopes. These smaller pumps may, therefore, have a more difficult time pumping out gas particles from the electron source. Further, tabletop electron microscopes have smaller beam columns and fewer apertures than floor models. This can result in higher operating pressures, which may result in a concentration of contamination in the electron source.

One solution to this issue may include increasing the negative bias voltage of the Wehnelt electrode (e.g., increasing the negative value of the voltage provided to the Wehnelt electrode). Although this may address the electric field of the Wehnelt electrode, this still does not address the root problem of the ionized gas particles forming a deposition layer along the Wehnelt electrode. Ignoring this deposition layer may lead to even further issues of the deposition layer flaking off (e.g., after thermal expansion and cooling of the deposition layer) and floating back onto the cathode electrode. This additional contamination layer on the cathode electrode may alter the direction of the electrons emitted from the cathode electrode and further disrupt the focus of the electron beam.

Another solution may include dismantling the electron source to physically clean off the contamination in the electron source. However, this poses additional challenges as dismantling the electron source may expose the chamber to potential contamination. This may, again, be a particular issue for tabletop electron microscopes as such microscopes are located in areas having varying cleanliness standards (e.g., labs or offices) and not generally placed in controlled, contaminant-free environments. Further, cleaning the electron source increases the risk that the electron microscope system has alignment issues. Another issue is that the relatively weak vacuum systems of tabletop SEMs are less able to de-gas the internal surfaces from adsorbed species, such as organic molecules and water.

The present disclosure provides a charged particle microscope system having an electron source with a dry environment that is substantially free of water. As water is a common vapor species that enters the charged particle microscope system and oxygen is a primary catalyst in the evaporation of material from the cathode electrode, providing a dry environment substantially free of water for the electron source can reduce the evaporation of material from the cathode electrode. In turn, this reduces the ionization of gas particles in the source section of the microscope system, and in turn reduces the formation of the deposition layer along the Wehnelt electrode and cathode electrode. Further, as reducing the presence of oxygen also reduces the oxidation and evaporation of the cathode electrode, the lifespan of the cathode electrode may be significantly improved (e.g., from 150 hours of use to greater than 1,500 hours).

However, removing water and/or oxygen from the electron source may also prove challenging. Because the electron source defines a first end of an unobstructed beam path between the cathode electrode and a sample position, the electron source is not sealed (e.g., airtight) during operation of the electron source. Accordingly, solutions to this issue may include both providing a substantially water-free or oxygen-free electron source while still allowing for an unobstructed path from the cathode electrode to the sample. Various embodiments providing such a solution will be discussed further below. One embodiment includes using a cold trap to condense water vapor that may be entering the electron source. Another embodiment includes introducing an inert gas into the electron source section. Yet another embodiment includes enclosing the charged particle microscope system in a dry environment.

Although the remaining portions of the description will routinely reference scanning electron microscopes (SEM), it will be readily understood by the skilled artisan that the technology is not so limited. The present designs may be employed with other types of charged particle microscope, such as transmission electron microscope (TEM), scanning transmission electron microscope (STEM), dual beam systems including an ion beam source and an electron beam source, reflection electron microscopes (REM), circuit editing microscopes, or the like. Accordingly, the disclosure and claims are not to be considered limited to any particular example microscope discussed, but can be utilized broadly with any number of electron microscopes that may exhibit some or all of the electrical or chemical characteristics of the discussed examples.

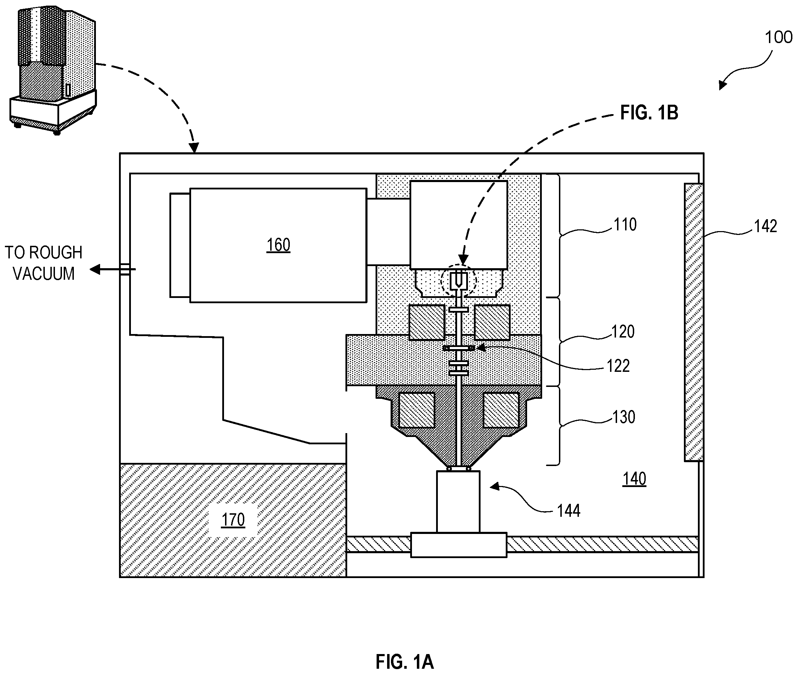

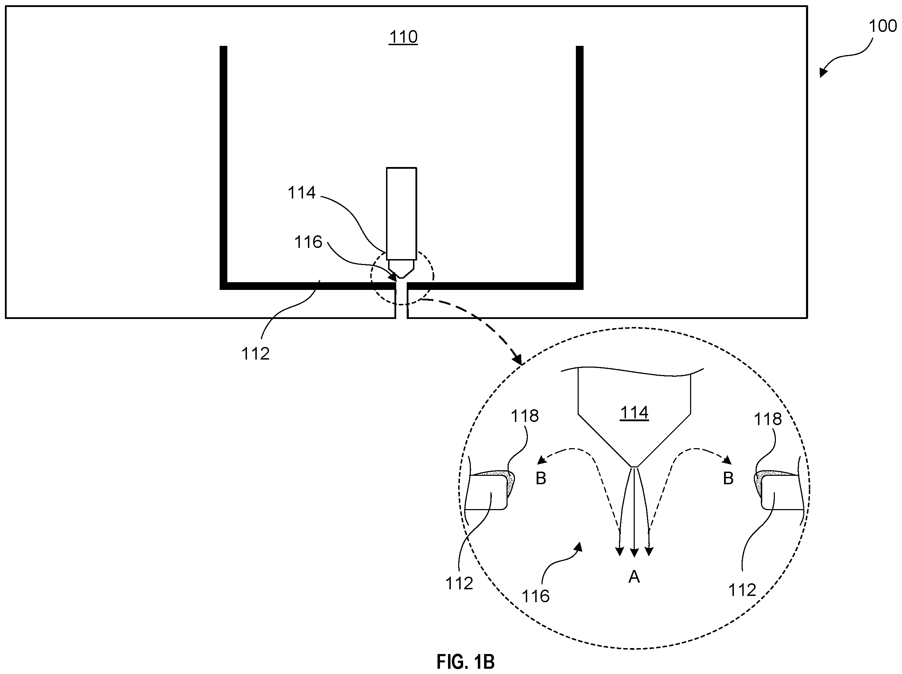

FIGS. 1A-1B depict an example charged particle microscope system 100 illustrating a system of focusing and controlling the emission current of an electron beam with a Wehnelt electrode. Turning to FIG. 1B, the electron microscope 100 may include multiple sections, including an electron source 110, beam column 120, objective lens 130, and vacuum chamber 140. The electron source 110 may include high-voltage supply components, vacuum system components, and an electron emitter configured to generate a beam of electrons that is accelerated into the beam column 120. The beam column 120 includes various beam steering components 122, such as electromagnetic lens elements, that are configured to shape and form the electron beam from the electron source 110 into a substantially circular beam with a substantially uniform profile to be focused onto a sample by the objective lens 130.

The beam of electrons is typically characterized by a beam current and an accelerating voltage applied to generate the beam, among other criteria. The ranges of beam current and accelerating voltage can vary between instruments and are typically selected based on material properties of the sample or the type of analysis being conducted. Generally, however, beams of electrons are characterized by an energy from about 0.1 keV (e.g., for an accelerating voltage of 0.1 kV) to about 50 keV and a beam current from picoamperes to microamperes.

The vacuum chamber 140 and/or the beam column 120 can include multiple detectors for various signals, including but not limited to secondary electrons generated by interaction of the beam of electrons and the sample, x-ray photons (e.g., energy-dispersive X-ray spectroscopy), other photons (e.g., visible and/or infrared cameras), and/or molecular species (e.g., time-of-flight secondary ion mass spectrometry). The vacuum chamber 140 can also include a sample holder 144 that can be operably coupled with a holder motion system 170 (e.g., a multi-axis translation/rotation control system), such that the sample holder 144 can be repositioned relative to the electron beam to optimally survey and/or image the sample held in the sample holder 144. The vacuum chamber door 142 provides access to the vacuum chamber 140 from outside of the charged particle microscope system 100 (e.g., for cleaning, changing the sample, or the like).

The turbopump 160 may generate the vacuum in the vacuum chamber 140 by generating a pressure differential by pumping materials from within the vacuum chamber 140. The vacuum chamber 140 may be devoid of matter to minimize the risk that any intervening matter within the vacuum chamber 140 disrupts the electron beam to the sample. The turbopump 160 may pump the vacuum chamber 140 (as well as any intervening components) to a pressure lower than about 10⁻¹⁰ Torr, such as less than or about 10⁻¹¹ Torr, such as less than or about 10⁻¹² Torr, or such as less than or about 10⁻¹³ Torr. The turbopump 160 may be in fluid communication with the vacuum chamber 140, objective lens 130, beam column 120, and electron source 110 to pump gas from the vacuum chamber 140. A path may be defined from the turbopump 160 through the electron source 110, the beam column 120, the objective lens 130, and to the sample holder 144, with the turbopump 160 defining the most upstream point and the sample holder 144 defining the most downstream point. In this manner, "downstream" and "upstream" may be relative terms used to describe the position of various components along this path.

Turning to FIG. 1B, the electron source 110 may include a Wehnelt electrode 112 and cathode electrode 114 (e.g., a cathode crystal). The cathode electrode 114 may be heated up (e.g., to around 1700-1800 Kelvin) with a voltage to emit an electron beam A from a tip of the cathode electrode 114. The cathode electrode 114 may be cerium hexaboride, lanthanum hexaboride, or other materials that can be used as electron emitter sources. The Wehnelt electrode 112 may define an aperture 116 downstream of the cathode electrode 114 to allow the electron beam A to pass through. The Wehnelt electrode 112 may be charged with a negative bias voltage to generate an electric field more negative than the voltage of the cathode electrode 114. This electric field focuses and controls the current emission of the electron beam A by surrounding the aperture 116 with the electric field so that any stray electrons leaving the electron beam A are repulsed by the electric field toward a centerline of the aperture 116. In this manner, an electron beam axis may be defined from the cathode electrode 114 to the sample holder 144. The amount of negative bias voltage provided to the Wehnelt electrode 112 may correlate with the amount of electron beam energy emitted from the cathode electrode 114.

However, as noted above, the emitted electrons may ionize gas particles that may be in the electron source 110. Such gas particles may be material evaporated from the cathode electrode 114, such as from oxidation of the cathode electrode 114. In other words, at least some of the gas particles within the electron source 110 may be a byproduct of the cathode electrode 114 reacting with oxygen in the electron source 110 (e.g., cerium, boride, oxide, or the like). However, while oxidation can play a role in contamination, it is not the only chemical mechanism by which performance of the electron source 110 is degraded. These gas particles may be ionized by to have an electric charge. At least some of these ionized gas particles B may be ionized to have a positive charge, leading to the ionized gas particles B being attracted to the Wehnelt electrode 112. The ionized gas particles B may form a deposition layer 118 along the Wehnelt electrode 112 and extending partially within the aperture 116.

This deposition layer 118 reducing the potential and electric field of the Wehnelt electrode 112. To counteract this reduced potential, the Wehnelt electrode 112 may need a greater negative voltage to maintain a desired electric field that focuses and controls the current emission of the electron beam A. Further, portions of the deposition layer 118 may flake off during the thermal expansion and cooling of the Wehnelt electrode 112 and deposition layer 118. These flakes may float to the cathode electrode 114 to form another deposition layer, which may further alter the direction of the electron beam A. As such, the presence of oxygen in the electron source 110 not only causes the faster degradation of the cathode electrode 114, oxygen also causes the formation of the deposition layer 118 and contributes to the misalignment of the electron beam A.

As oxygen is a chemical component of water, which is a common vapor that may infiltrate the electron source 110, removing the water from the electron source 110 (e.g., from the volume between the Wehnelt electrode 112 and the cathode electrode 114) such that the electron source 110 is a dry environment may be beneficial to prevent the degradation of the cathode electrode 114. For example, the electron source 110 may be a dry environment when the electron source 110 includes less than about 5% humidity, less than about 4% humidity, less than about 3% humidity, less than about 2% humidity, less than about 1% humidity, or completely free of any humidity. In one example, the electron source 110 may be a dry environment when the electron source includes 0.01% humidity. In other embodiments, the electron source 110 may be a dry environment when the electron source 110 substantially oxygen-free. For example, the electron source 110 may include less than about 5% of oxygen, less than about 4% of oxygen, less than about 3% of oxygen, less than about 2% of oxygen, less than about 1% of oxygen, or completely free of any oxygen.

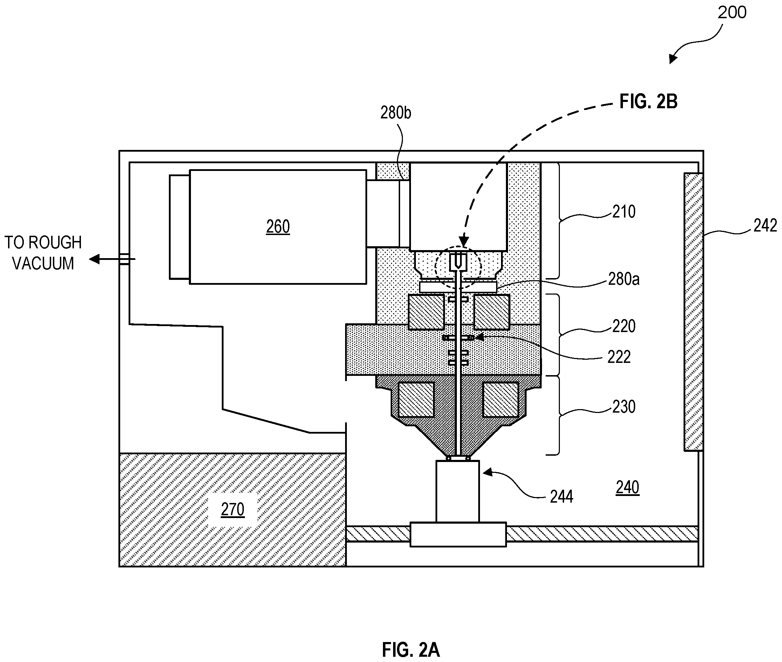

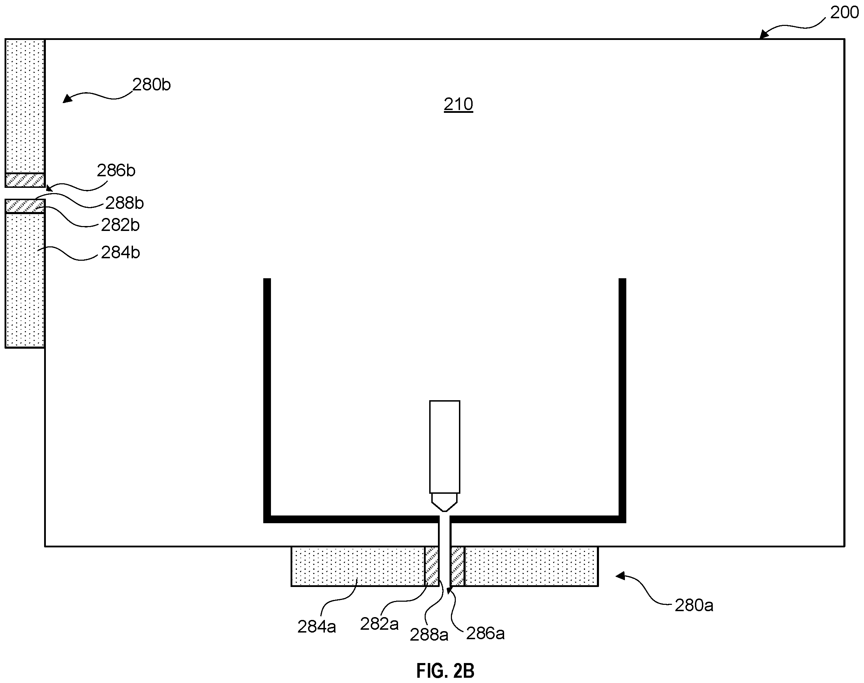

FIGS. 2A and 2B depict an example charged particle microscope system 200. It is understood that features ending in like reference numerals as features discussed above are similar, except as noted below. The charged particle microscope system 200 includes a first cold trap 280a and a second cold trap 280b. The first cold trap 280a may be positioned downstream of the electron source 210, between the electron source 210 and the beam column 220. However, in some embodiments, the first cold trap may be positioned in the beam column downstream of the electron source The second cold trap 280b may be positioned upstream of the electron source 210, between the electron source 210 and the turbopump 260. The cold traps 280a, 280b may condense and trap water vapor in the charged particle microscope system 200 just upstream and downstream of the electron source 210 to prevent water from entering the electron source 210 such that the electron source 210 is substantially water-free. The first cold trap 280a may be positioned just downstream of the electron source 210 so that any water vapor in the gas flowing into the electron source 210 from the beam column 220 may be condensed and trapped before water enters the electron source 210. The second cold trap 280b may be positioned just upstream of the electron source 210 so that any water vapor in gas that may backstream from the turbopump 260 back into the electron source 210 is condensed and trapped before entering the electron source 210. Although two cold traps 280a, 280b are depicted, in some embodiments, only one cold trap (e.g., the cold trap downstream of the electron source) is included in the microscope system.

Turning to FIG. 2B, the first cold trap 280a may include a first cold structure 282a and a first heat-removal element 284a coupled to the first cold structure 282a. The second cold trap 280b may include a second cold structure 282b and a second heat-removal element 284b coupled to the second cold structure 282b. The first and second cold structures 282a, 282b may be made of glass, steel, or the like. The heat-removal elements 284a, 284b may include a coolant (e.g., liquid nitrogen, dry ice in acetone, chill water, or the like) that is circulated within the heat-removal elements 284a, 284b to remove heat from the cold structures 282a, 282b such that the cold structures 282a, 282b can have a temperature that cools water vapor entering the cold structures 282a, 282b into a solid or liquid. For example, the heat-removal elements 284a, 284b may respectively include circulating elements (e.g., coils, tubes, channels, etc. and one or more pumps for circulating coolant within coils, tubes, channels, etc.) circulating coolant from a reservoir such that the coolant absorbs heat from the cold structures 282a, 282b before being circulated away. In some embodiments, the heat-removal elements 284a, 284b may be fluidly coupled to a reservoir housing the coolant, however, in other embodiments, the heat-removal elements may include the reservoir with the coolant. In some embodiments, the heat-removal elements 284a, 284b may use thermoelectric cooling, such as using a Peltier cooling system, to transfer heat away from the cold structures 282a, 282b. In other embodiments, other means of means of removing heat with the heat-removal systems are envisioned.

The first and second cold structures 282a, 282b respectively includes first and second cold surfaces 288a, 288b that traps condensed water. For example, the cold surfaces 288a, 288b may be adsorbent such that the cold surfaces 288a, 288b are an adsorbent surface that collects condensed water along the cold surfaces 288a, 288b. However, in other embodiments, the cold surfaces may be made of an absorbent material, such that the cold surfaces are an absorbent surface that absorbs condensed water within the cold surface. The cold surfaces 288a, 288b may be cylindrical, however, in other embodiments, the cold surfaces can have any geometric shape, including conical, cuboid, or the like.

The first and second cold surfaces 288a, 288b may respectively define the region within the cold structures 282a, 282b that is cooled by the heat-removal elements 284a, 284b as first and second cold regions 286a, 286b. The cold structures 282a, 282b may be cooled to a temperature substantially lower than the freezing point of water at the pressures created by the turbopump 260, such as less than about -50 °C, such as less than about -85 °C, or less than about -105 °C. In this manner, any water vapor entering the cold regions 286a, 286b may be rapidly cooled and condensed before being trapped along the cold surfaces 288a, 288b. In some embodiments, the cold structures may be cooled to a temperature substantially lower than the freezing point of oxygen at the pressures created by the turbopump, such as less than about -180 °C, such as less than about -190 °C, or such as less than about -200°C. In this manner, oxygen may be cooled and condensed before being trapped along the cold surfaces of the cold traps.

In some embodiments, the cold structures 282a, 282b may include a web structure to increase the surface-to-volume ratio of the cold structures 282a, 282b. The web structure may define a plurality of channels for the passage of gas to and from the electron source 210 with a plurality of cold regions defined within those channels to condense water vapor on the surfaces of the channels. Accordingly, the web structure may increase the amount of surfaces used to trap any condensed water vapor passing through the cold regions 286a, 286b. The web structure may include a honeycomb shape to define hexagonal channels, however, in other embodiments, the web structure may have other shapes, such as defining cylindrical channels, rectangular channels, tapered channels, a plurality of baffles, or the like. In some embodiments, the first cold structure 282a of the first cold trap 280a may additionally define a central aperture through this web structure to allow for electrons to pass from the electron source 210 uninhibited to the beam column 220. The second cold structure 282b of the second cold trap 280b may not define a central aperture and, instead, may be substantially entirely a web structure to maximize the entrapment of backstreamed water vapor.

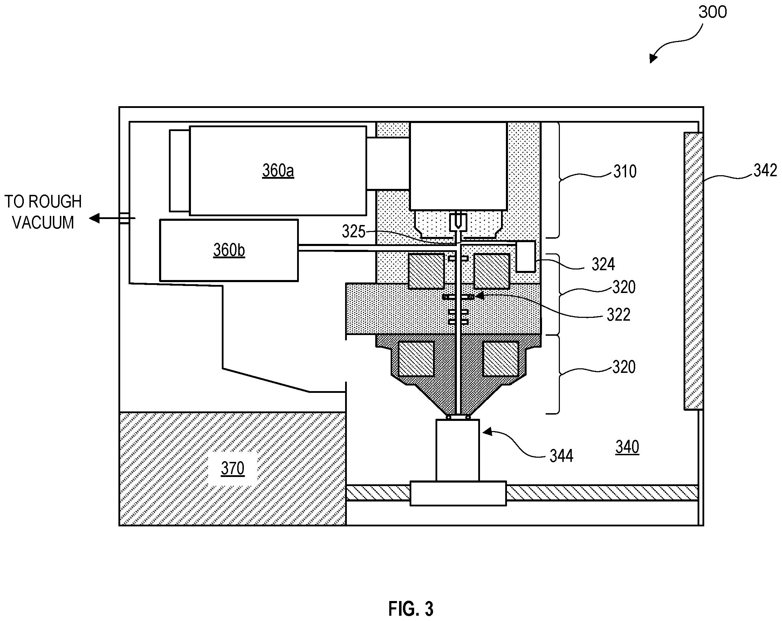

FIG. 3 depicts an example charged particle microscope system 300. It is understood that features ending in like reference numerals as features discussed above are similar, except as noted below. The charged particle microscope system 300 includes a first turbopump 360a, a second turbopump 360b, and a gas reservoir 324. The second turbopump 360b may be similar to the first turbopump 360a except the second turbopump 360b may pump to a higher pressure than the first turbopump 360a. For example, the first turbopump 360a may pump to a first pressure of lower than about 10⁻¹⁰ Torr, such as less than or about 10⁻¹¹ Torr, such as less than or about 10⁻¹² Torr, or such as less than or about 10⁻¹³ Torr. The second turbopump 360b may pump to a second pressure of greater than about 10⁻¹³ Torr and less than about 10⁻⁶ Torr. For example the second pressure may be greater than or about 10⁻¹² Torr, greater than or about 10⁻¹¹ Torr, or greater than or about 10⁻¹⁰ Torr. The second pressure may less than or about 10⁻⁶ Torr, less than or about 10⁻⁷ Torr, less than or about 10⁻⁸ Torr, or less than or about 10⁻⁹ Torr. However, other pressure values are envisioned. In this manner, a consistent gas flow path may be maintained from the vacuum chamber 340, past the second turbopump 360b, and to the first turbopump 360a.

The second turbopump 360b may collect water vapor as the second turbopump 360b pumps in gas from the vacuum chamber 340. Accordingly, the second turbopump 360b may decrease the amount of water vapor that may enter the electron source 310 by collecting at least some, if not all, of the water vapor downstream of the electron source 310. As such, gas entering the electron source 310 upstream of the second turbopump 360b may be substantially water-free. In other embodiments, there may be more than two turbopumps, such as three, four, or the like. For example, there may be one or more turbopumps for each of the beam column, objective lens, and/or the vacuum chamber. These other turbopumps may be positioned downstream of the second turbopump and may each pump to a greater pressure the farther downstream the turbopump is. In this manner, a consistent gas flow path can still be maintained from the vacuum chamber, through the plurality of turbo turbopumps, and to the first turbopump.

The gas reservoir 324 may house an inert gas and may be in fluid communication with the first turbopump 360a such that the first turbopump 360a transports at least a portion of the inert gas from the gas reservoir 324 into the electron source 310. The inert gas may be a gas that does not ionize easily. For example, the inert gas may be argon, nitrogen, dry air, helium, or the like. The gas reservoir 324 may be positioned in the beam column 320, however, in other embodiments, the gas reservoir may be a separate component housed outside of the beam column. In some embodiments, the outlet 325 may be positioned in the beam column 320 downstream of the electron source 310 and upstream of the second turbopump 360b. In other embodiments, the outlet may be positioned upstream of the beam column. As such, the pressure at the outlet 325 may be less than the pressure created by the second turbopump 360b and greater than the pressure created by the first turbopump 360a in the electron source 310. In this manner, the inert gas from the gas reservoir 324 may be transported by the first turbopump 360a into the electron source 310. As the second turbopump 360b collects water vapor downstream of the gas reservoir 324, the gas entering the electron source 310 may be substantially entirely the inert gas and may be substantially water-free. Accordingly, degradation of the cathode electrode may be minimized and the lifespan of the cathode electrode may be increased.

In some embodiments, one or more cold traps (e.g., similar to the cold traps 260a, 260b of FIGS. 2A-2B) may be used to further ensure that the electron source 310 is substantially water-free. For example, cold traps may be positioned downstream of the second turbopump and just upstream of the second turbopump, but downstream of the outlet of the gas reservoir. Accordingly, any water vapors that may not have been collected by the second turbopump may be condensed and trapped within one of the first or second cold traps before entering the electron source. Additionally, a third cold trap may be positioned between the first turbopump and the electron source to condense and trap any backstream water vapor from the first turbopump, similar to the second cold trap 280b. In a yet further embodiment, there may be one or more cold traps and one or more pumps, as discussed above, but no gas reservoir housing inert gas.

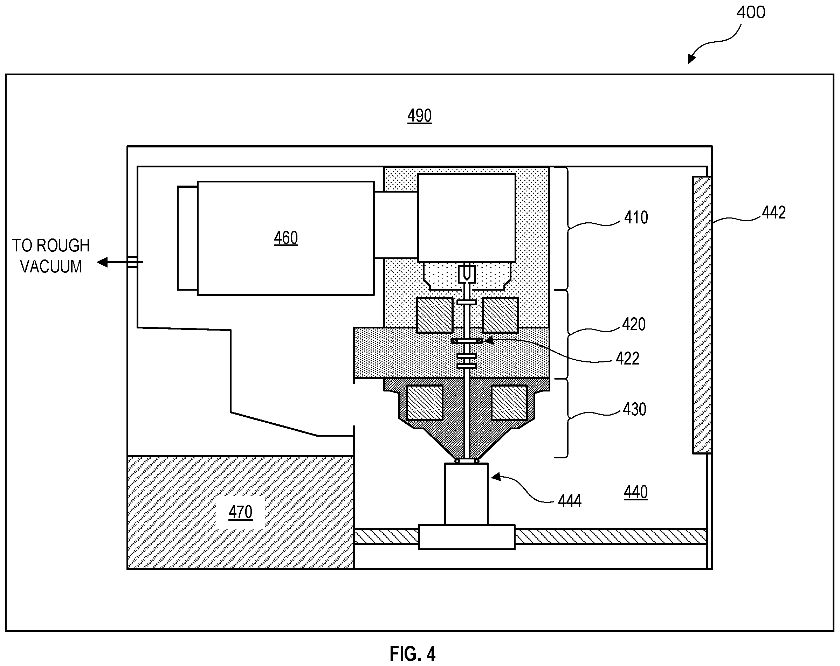

FIG. 4 depicts an example charged particle microscope system 400. It is understood that features ending in like reference numerals as features discussed above are similar, except as noted below. The electron source 410, the beam column 420, the objective lens 430, the vacuum chamber 440, the sample holder 444, the turbopump 460, and the holder motion system 470 may be positioned in a substantially water-free container 490. The container 490 may be a glovebox, room, or the like that is substantially water-free. Instead, the container 490 may entirely contain an inert gas such that the electron source 410 may only include the inert gas. For example, an external pump may pump substantially all of the water from within the container 490 while drawing in an inert gas into the container until the entirety of the internal volume of the container 490 is substantially water-free (e.g., until the container includes a dry internal volume), including the electron source 410.

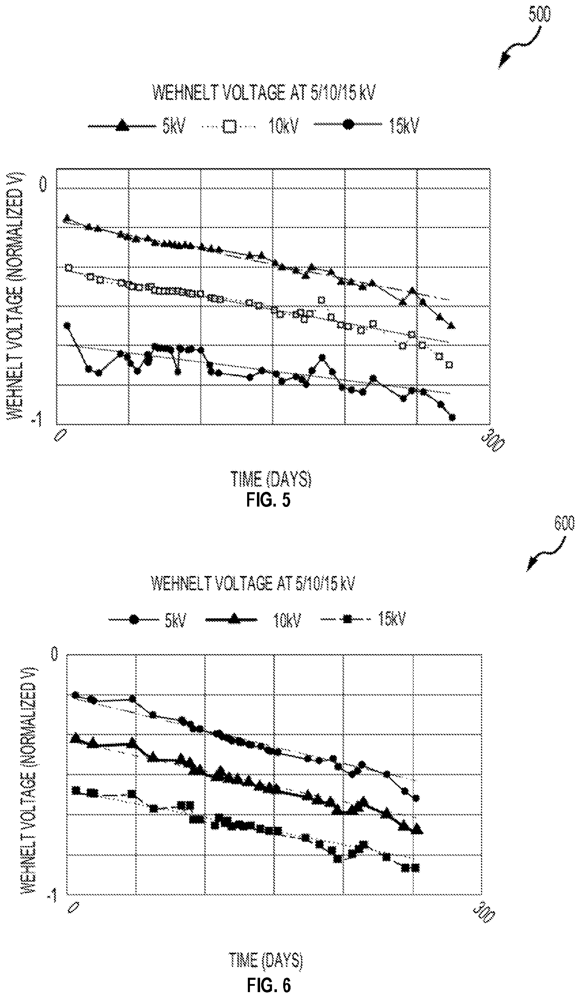

FIGS. 5 and 6 respectively depict example graphs 500, 600 of a charged particle microscope system that does not have a substantially water-free electron source. The graphs 500, 600 depict the voltage being applied to the Wehnelt electrode (e.g., the Wehnelt voltage) decreasing over time. In other words, the negative bias voltage of the Wehnelt electrode is being increased over time. As discussed above, this is caused by contamination layer deposition on the Wehnelt electrode. As this deposit layer interferes with the electric field generated by the Wehnelt electrode, the negative bias of the Wehnelt electrode must be increased over time to ensure that the electron beam current is stable. These graphs 500, 600, therefore, provide a numerical representation of the consequences of an electron microscopy system that does not have a substantially water-free electron source.

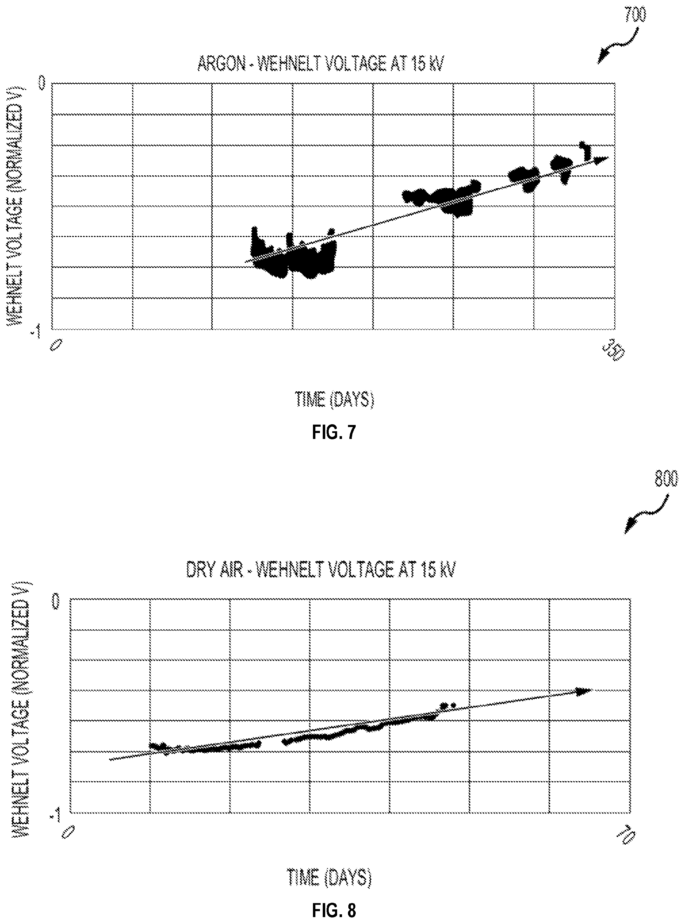

FIGS. 7 and 8 respectively depict example graphs 700, 800 of a charged particle microscope system that has a substantially water-free electron source. Specifically, the graph 700 depicts an example charged particle microscope system with a substantially water-free electron source that uses argon and the graph 800 depicts an example charged particle microscope system with a substantially water-free electron source that uses dry air. As shown, for both of these systems, the negative bias of the voltage provided to the Wehnelt is not increasing but, rather, decreasing (i.e., the voltage is increasing in value). This indicates, compared to the cathode electrode of the charged particle microscope systems for the graphs 500, 600, that the cathode electrodes of the charged particle microscope system of the graphs 700, 800 have significantly less degradation over time. Either of argon or dry air may be preferable depending on the sample (e.g., reactivity of the sample to the type of gas), environment of the charged particle microscope system, and type of the charged particle microscope system. Whereas the lifespan of cathode electrodes for electron sources that are not substantially water-free may be about 150 hours, the degradation of the cathode electrode may be minimized in substantially water-free electron sources such that the lifespan of these cathode electrode may increase to about 1,500 hours (or even greater).

In the foregoing specification, embodiments of the disclosure have been described with reference to numerous specific details that can vary from implementation to implementation. The specification and drawings are, accordingly, to be regarded in an illustrative rather than a restrictive sense. The sole and exclusive indicator of the scope of the disclosure, and what is intended by the applicants to be the scope of the disclosure, is the literal and equivalent scope of the set of claims that issue from this application, in the specific form in which such claims issue, including any subsequent correction. The specific details of particular embodiments can be combined in any suitable manner without departing from the spirit and scope of embodiments of the disclosure.

Additionally, spatially relative terms, such as "bottom or "top" and the like can be used to describe an element and/or feature's relationship to another element(s) and/or feature(s) as, for example, illustrated in the figures. It will be understood that the spatially relative terms are intended to encompass different orientations of the device in use and/or operation in addition to the orientation depicted in the figures. For example, if the device in the figures is turned over, elements described as a "bottom" surface can then be oriented "above" other elements or features. The device can be otherwise oriented (e.g., rotated 90 degrees or at other orientations) and the spatially relative descriptors used herein interpreted accordingly.

Terms "and," "or," and "an/or," as used herein, may include a variety of meanings that also is expected to depend at least in part upon the context in which such terms are used. Typically, "or" if used to associate a list, such as A, B, or C, is intended to mean A, B, and C, here used in the inclusive sense, as well as A, B, or C, here used in the exclusive sense. In addition, the term "one or more" as used herein may be used to describe any feature, structure, or characteristic in the singular or may be used to describe some combination of features, structures, or characteristics. However, it should be noted that this is merely an illustrative example and claimed subject matter is not limited to this example. Furthermore, the term "at least one of' if used to associate a list, such as A, B, or C, can be interpreted to mean any combination of A, B, and/or C, such as A, B, C, AB, AC, BC, AA, AAB, ABC, AABBCCC, etc.

Reference throughout this specification to "one example," "an example," "certain examples," or "exemplary implementation" means that a particular feature, structure, or characteristic described in connection with the feature and/or example may be included in at least one feature and/or example of claimed subject matter. Thus, the appearances of the phrase "in one example," "an example," "in certain examples," "in certain implementations," or other like phrases in various places throughout this specification are not necessarily all referring to the same feature, example, and/or limitation. Furthermore, the particular features, structures, or characteristics may be combined in one or more examples and/or features.

In some implementations, operations or processing may involve physical manipulation of physical quantities. Typically, although not necessarily, such quantities may take the form of electrical or magnetic signals capable of being stored, transferred, combined, compared, or otherwise manipulated. It has proven convenient at times, principally for reasons of common usage, to refer to such signals as bits, data, values, elements, symbols, characters, terms, numbers, numerals, or the like. It should be understood, however, that all of these or similar terms are to be associated with appropriate physical quantities and are merely convenient labels. Unless specifically stated otherwise, as apparent from the discussion herein, it is appreciated that throughout this specification discussions utilizing terms such as "processing," "computing," "calculating," "determining," or the like refer to actions or processes of a specific apparatus, such as a special purpose computer, special purpose computing apparatus or a similar special purpose electronic computing device. In the context of this specification, therefore, a special purpose computer or a similar special purpose electronic computing device is capable of manipulating or transforming signals, typically represented as physical electronic or magnetic quantities within memories, registers, or other information storage devices, transmission devices, or display devices of the special purpose computer or similar special purpose electronic computing device.

In the preceding detailed description, numerous specific details have been set forth to provide a thorough understanding of claimed subject matter. However, it will be understood by those skilled in the art that claimed subject matter may be practiced without these specific details. In other instances, methods and apparatuses that would be known by one of ordinary skill have not been described in detail so as not to obscure claimed subject matter. Therefore, it is intended that claimed subject matter not be limited to the particular examples disclosed, but that such claimed subject matter may also include all aspects falling within the scope of appended claims, and equivalents thereof.

## Claims

1. A charged particle microscope system, comprising:
an electron source housing a Wehnelt electrode and a cathode, wherein the electron source includes a dry environment defining a volume between the Wehnelt electrode and the cathode that is substantially water-free;
a beam column including a plurality of electromagnetic lens elements; and
a vacuum chamber including a sample holder, wherein an electron beam axis is defined from the cathode to the sample holder.

2. The charged particle microscope system of claim 1, wherein the dry environment is substantially water-free when the dry environment includes less than 5% humid.

3. The charged particle microscope system of claim 1, wherein the dry environment is substantially oxygen-free, preferably when the dry environment includes less than 5% oxygen.

4. The charged particle microscope system of claim 1,
further comprising a first cold trap positioned between the beam column and the Wehnelt electrode, and
wherein the first cold trap includes:
a first adsorbent surface defining a first cold region at a first temperature substantially lower than a freezing point of water; and
a first heat-removal element coupled to the first cold surface.

5. The charged particle microscope system of claim , wherein the first heat-removal element includes a Peltier cooling system.

6. The charged particle microscope system of claim , wherein the first heat-removal element includes at least one of a circulating element in fluid communication with a reservoir housing coolant.

7. The charged particle microscope system of claim , wherein the coolant includes at least one of a liquid nitrogen or dry ice in acetone.

8. The charged particle microscope system of claim ,
further comprising:
a turbopump in fluid communication with the electron source;
a second cold trap positioned between the turbopump and the electron source,
wherein the second cold trap includes:
a second adsorbent surface defining a second cold region at a second temperature substantially lower than a freezing point of water; and
a second heat-removal element coupled to the second cold surface.

9. The charged particle microscope system of claim , wherein:
the second adsorbent surface includes a plurality of channels; and
the plurality of channels each define a channel cold region.

10. The charged particle microscope system of claim 1,
further comprising:
an inert gas reservoir housing an inert gas and including an outlet in fluid communication with the electron source; and
a first turbopump in fluid communication with the electron source and the outlet to transport at least a portion of the inert gas into the dry environment, and
wherein the first turbopump creates a first pressure in the electron source greater than a second pressure at the outlet.

11. The charged particle microscope system of claim ,
further comprising a second turbopump in fluid communication with the vacuum chamber and beam column, wherein:
the outlet is positioned between the electron source and the second turbopump; and
the second turbopump creates a third pressure in the beam column greater than the second pressure.

12. The charged particle microscope system of claim , further comprising a third turbopump in fluid communication with the vacuum chamber, wherein the third turbopump creates a fourth pressure greater than the third pressure.

13. The charged particle microscope system of claim , wherein the inert gas includes at least one of argon, nitrogen, dry air, and helium.

14. The charged particle microscope system of claim , wherein the outlet is positioned in the beam column.

15. The charged particle microscope system of claim 1, further comprising a container housing the electron source, beam column, and the vacuum chamber, wherein the container includes a dry internal volume.
